Europäisches Patentamt

European Patent Office

Office européen des brevets

(19)

(11) Veröffentlichungsnummer: **0 366 656 B1**

(12)

# EUROPÄISCHE PATENTSCHRIFT

(45) Veröffentlichungstag der Patentschrift:
24.07.91 Patentblatt 91/30

(51) Int. Cl.⁵: **G11C 17/00**

(21) Anmeldenummer: 88903771.9

(22) Anmeldetag: 05.05.88

(86) Internationale Anmeldenummer:
PCT/DE88/00273

(87) Internationale Veröffentlichungsnummer:
WO 88/09997 15.12.88 Gazette 88/27

(54) **VERBINDUNGSNETZWERK ZUR EINSTELLBAREN VERBINDUNG VON SCHALTUNGSANORDNUNGEN, INSBESONDERE PROGRAMMIERBAREN SCHALTUNGSANORDNUNGEN.**

(30) Priorität: 05.06.87 DE 3718916

(43) Veröffentlichungstag der Anmeldung:
09.05.90 Patentblatt 90/19

(45) Bekanntmachung des Hinweises auf die
Patenterteilung:
24.07.91 Patentblatt 91/30

(84) Benannte Vertragsstaaten:
DE FR GB IT

(56) Entgegenhaltungen:
US-A- 3 818 452
Patent Abstracts of Japan, Band 9, Nr. 310 (E 364)(2033), 6. Dezember 1985

(73) Patentinhaber: Siemens Aktiengesellschaft
Wittelsbacherplatz 2
W-8000 München 2 (DE)

(72) Erfinder: GLÄSER, Winfried
Hansjakobstrasse 125 b
W-8000 München 82 (DE)
Erfinder: SCHÜTT, Dieter, Prof., Dr.
Dachsteinstrasse 26 a
W-8000 München 82 (DE)

EP 0 366 656 B1

## Beschreibung

Für manche Anwendungsfälle ist es erforderlich, daß eine Mehrzahl von Schaltungsanordnungen einstellbar miteinander verbunden werden können. Dabei kann jede dieser Schaltungsanordnung Sender oder Empfänger sein. Dies kann der Fall sein, wenn mehrere prorammierbare Schaltungen, abgekürzt PLA, in einem Schaltwerk zusammengefaßt werden. Derartige programmierbare Schaltungen enthalten eine UND-Ebene und eine ODER-Ebene. In der UND-Ebene erfolgt die Verknüpfung der Eingangssignale entsprechend einer in der UND-Ebene gespeicherten Funktionstabelle. Diese Verknüpfungsergebnisse der UND-Ebene, die auch Produktterme genannt werden, werden der ODER-Ebene zugeführt und dort entsprechend der in der ODER-Ebene enthaltenen Funktionstabelle zu den sog. Summentermen verküpft. Die Summenterme werden an den Ausgängen der ODER-Ebene abgegeben. Ein derartiges PLA verfügt über Eingangsleitungen, die zu der UND-Ebene führen, und über Ausgangsleitungen, die aus der ODER-Ebene herausführen.

Aus US-A-3 818 452 ist eine derartige programmierbare Schaltungsanordnung bekannt. Hier besteht die UND-Ebene aus einer Matrix mit Eingangsleitungen, Koppelleitungen und mit an den Kreuzungsstellen von Eingangsleitungen und Koppelleitungen angeordneten programmierbaren Koppelelementen. Die ODER-Ebene enthält ebenfalls eine Matrix mit Koppelleitungen, Ausgangsleitungen und an den Kreuzungsstellen angeordneten Koppelelementen.

Der Aufbau einer programmierbaren Schaltungsan-ordnung kann auch derart sein, daß die UND-Ebene und die ODER-Ebene zusammengefaßt ist und es möglich ist, durch Programmierung festzulegen, ob die in die programmierbare Schaltungsan-ordnung hineinführenden Leitungen, in Zukunft Datenleitungen genannt, Eingangsleitungen oder Ausgangsleitungen sein sollen.

Die der Erfindung zugrundeliegende Aufgabe besteht darin, ein Verbindungsnetzwerk zur einstellbaren Verbindung von Schaltungsanordnungen anzugeben, die entweder als Sender oder als Empfänger arbeiten. Diese Aufgabe wird bei einem Verbindungsnetzwerk der eingangs angegebenen Art gemäß den in Patentanspruch 1 angegebenen Merkmalen gelöst.

Das Verbindungsnetzwerk beruht auf dem Prinzip des bidirektionalen PLA, also einer programmierbaren Schaltungsanordnung, bei dem die als Datenleitungen verwendeten Leitungen sowohl als Eingangsleitung als auch als Ausgangsleitung mit Hilfe eines Steuersignals einstellbar sind. Die Verbindung der Datenleitungen innerhalb der Verbindungsmatrix erfolgt mit Hilfe der Einstellmatrix.

Der Vorteil dieses Verbindungsnetzwerkes ist darin zu sehen, daß durch Programmierung der Koppelelemente in der Matrix entsprechend einer Verbindungstabelle jede Datenleitung mit jeder Datenleitung verbunden werden kann und zu dem die Richtung der Datenübertragung festgelegt werden kann.

Andere Weiterbildungen der Erfindung ergeben sich aus den Unteransprüchen. Anhand von Ausführungsbeispielen, die in den Figuren dargestellt sind, wird die Erfindung weiter erläutert. Es zeigen

| | |
|---|---|
| Fig. 1 | ein Blockschaltbild des Verbindungsnetzwerkes zur Verbindung von vier Schaltungsanordnungen, |
| Fig. 2 | ein weiteres Blockschaltbild des Verbindungsnetzwerkes, |
| Fig. 3 | ein Prinzipschaltbild der im Verbindungsnetzwerk verwendeten Matrix, |
| Fig. 4 | ein Stromlaufplan der Matrix, |
| Fig. 5 und Fig. 6 | Beispiele einer programmierten Matrix, |
| Fig. 7, 8 | Beispiele für den Verbindungsaufbau zwischen zwei Schaltungsanordnungen, |
| Fig. 9, 10 | weitere Beispiele für die Verbindung von Schaltungsanordnungen mit Hilfe des Verbindungsnetzwerkes. |

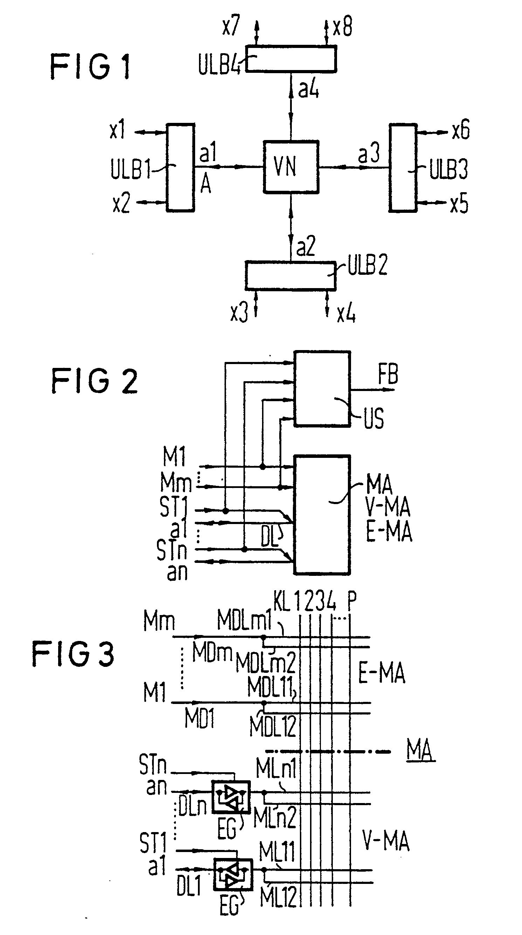

Aus Fig. 1 ergibt sich ein Blockschaltbild, bei dem vier Schaltungsanordnungen ULB1 bis ULB4 über ein Verbindungsnetzwerk VN miteinander verbunden werden können. Als Schaltungsanordnungen ULB können bidirektionale programmierbare Schaltungsanordnungen als Beispiel vorgesehen sein. Diese programmierbaren Schaltungsanordnungen haben Leitungen, auf denen Signale X zugeführt oder abgenommen werden und Anschlüsse A, die über das Verbindungsnetzwerk VN miteinander verbunden werden sollen. Von den Anschlüssen A der programmierbaren Schaltungsanordnungen ULB führen deswegen Datenübertragungsleitungen zum Verbindungsnetzwerk VN. Das Verbindungsnetzwerk VN ist derart aufgebaut, daß diese Leitungen im Verbindungsnetzwerk miteinander verbunden werden können und die Richtung der Datenübertragung einstellbar ist. Das heißt die Signale a auf den Datenübertragungsleitungen zwischen den programmierbaren Schaltungsanordnungen ULB und dem Verbindungsnetzwerk VN können einstellbar in der einen oder in der entgegengesetzten Richtung übertragen werden.

Fig. 2 zeigt ein Blockschaltbild des Verbindungsnetzwerkes VN. Dieses kann bestehen aus einer Matrix MA und aus einer Überwachungsschaltung US. Das Kernstück des Verbindungsnetzwerkes VN ist dabei die Matrix MA. Diese besteht aus einer Verbindungsmatrix V-MA und einer Einstellmatrix E-MA. Die Datenübertragungsleitungen führen als Datenleitungen DL 1 bis DLn (n = 1...) in die Verbindungsmatrix V-MA hinein. Die Richtung der Übertragung der Signale a auf den Datenleitungen DL wird mit Hilfe eines Steuersignals ST1 bis STn festgelegt. Innerhalb der Verbindungsmatrix V-MA wird die Verbindung zwischen den Datenleitungen DL realisiert. Diese Verbindung zwischen den Datenleitungen DL wird mit Hilfe der Einstellmatrix E-MA beeinflußt. Der Einstellmatrix E-MA werden Einstellsignale MI bis Mn zugeführt, die mit Hilfe der Einstellmatrix E-MA die Verbindungen zwischen den Datenleitungen DL festlegen.

Mit Hilfe einer Überwachungseinrichtung US, die zusätzlich vorgesehen sein kann, ist es möglich, zu überprüfen, ob der Verbindungsaufbau fehlerhaft ist oder nicht.

Mit Hilfe der Fig. 3 wird der Aufbau der Matrix MA weiter erläutert. Die Matrix MA besteht aus der Verbindungsmatrix V-MA und der Einstellmatrix E-MA. Die Verbindungsmatrix V-MA ist aus sich kreuzenden Datenleitungen DL und Koppelleitungen KL, die Einstellmatrix E-MA aus sich kreuzenden Einstelleitungen MD und den Koppelleitungen KL aufgebaut. Zur Programmierung der Matrix MA ist es vorteilhaft, wenn die Datenleitungen DL sich in zwei Matrixleitungen ML pro Datenleitung DL verzweigen und entsprechend die Einstelleitungen MD in jeweils zwei Einstellteilleitungen MDL verzweigen. Damit entstehen jeweils pro Koppelstelle zwischen einer Datenleitung bzw. Einstelleitung und einer Koppelleitung KL jeweils zwei Verbindungsmöglichkeiten.

Die Richtung der Übertragung von Daten a auf den Datenleitungen DL wird mit Hilfe von Steuersignalen ST festgelegt, die einer in der Datenleitung angeordneten Eingangsschaltung EG zugeleitet werden.

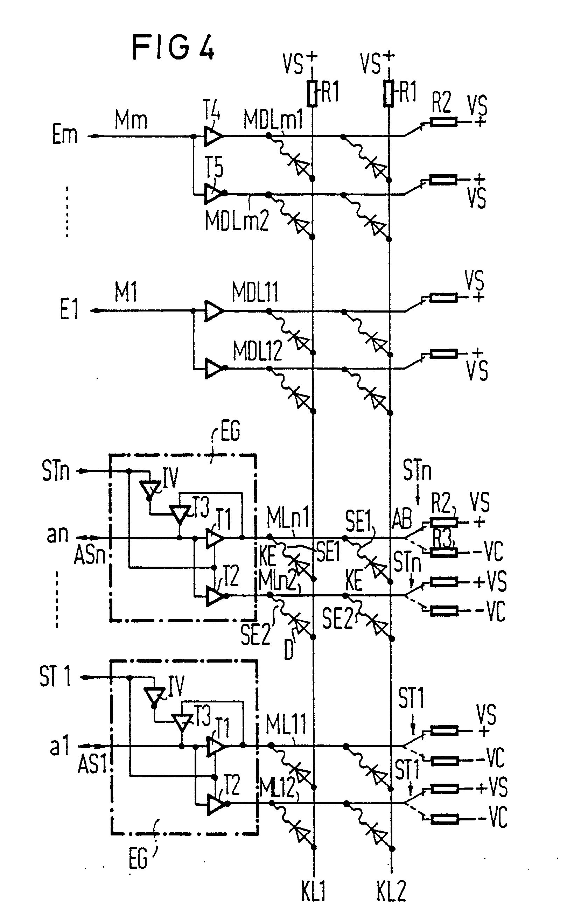

Eine Realisierung der Matrix kann Fig. 4 entnommen werden. Aus Fig. 4 ergibt sich, daß an den Koppelstellen Koppelelemente KE angeordnet sind, die jeweils aus zwei Schaltelementen SE1, SE2 bestehen. Diese Schaltelemente SE sind abschaltbar. Sie können z.B. aus einer Diode D und aus einer Sicherung F bestehen, die durchbrennbar ist. Mit zwei Schaltelementen pro Koppelelement KE können drei Zustände gespeichert werden, z.B. eine binäre 1, eine binäre 0 und ein dritter Zustand. Die binäre 1 kann dann z.B. gespeichert sein, wenn das Schaltelement SE1 zwischen der Matrixleitung ML1 und einer Koppelleitung KL nicht abgeschaltet ist, das Schaltelement SE2 zwischen der Matrixleitung ML2 und der Koppelleitung KL dagegen abgeschaltet ist. Eine binäre 0 ist dann gespeichert, wenn das Schaltelement SE2 zwischen der Matrixleitung ML2 und der Koppelleitung KL nicht abgeschaltet ist, das Schaltelement SE1 zwischen der Matrixleitung ML1 und der Koppelleitung KL dagegen abgeschaltet. Der dritte Zustand ist dann gespeichert, wenn beide Schaltelemente SE1, SE2 abgeschaltet sind.

Die Matrixleitungen ML1, ML2 sind entweder über einen Widerstand R2 mit der Betriebsspannungsquelle VS oder über einen Widerstand R3 mit der Betriebsspannungsquelle VC verbindbar. VS kann 5 Volt sein, VC 0 Volt. Die Umschaltung kann mit Hilfe eines Umschalters AB erfolgen. Die Umschaltung erfolgt in Abhängigkeit des Steuersignals ST. Ist das Steuersignal derart, daß eine Datenleitung DL als Eingang geschaltet ist, also der Datenanschluß AS ein Dateneingang ist, und damit Treiberstufen T1, T2 durchlässig gesteuert sind, dann sind die Matrixleitungen ML mit der Betriebsspannungsquelle VS verbunden. Soll jedoch eine Datenleitung DL in Abhängigkeit des Steuersignals ST als Ausgang betrieben werden, dann sind die Treiberstufen T1 und T2 abgeschaltet und eine Treiberstufe T3, die vorher abgeschaltet war, ist eingeschaltet. Dann müssen die Matrixleitungen M1 mit der Betriebsspannungsquelle VC verbunden sein.

Die Koppelleitungen KL sind über einen Widerstand R1 mit der ersten Betriebsspannungsquelle VS verbunden.

Die Einstellmatrix E-MA ist entsprechend der Verbindungsmatrix V-MA aufgebaut. Doch sind die Einstellteilleitungen MDL über den Widerstand R2 nur mit der Betriebsspannungsquelle VS verbunden. In den Einstellteilleitungen MDL liegen ebenfalls Treiberstufen T4, T5.

Für jede gewünschte Verbindungsmöglichkeit zwischen den Datenleitungen DL gibt es einen Einstellcode, der über die Einstellanschlüsse E1 bis Em zur Einstellmatrix E-MA gelangt. Zur Programmierung wird dazu eine Verbindungstabelle folgendermaßen aufgestellt :
— Die Anzahl der notwendigen Einstellanschlüsse E ist log 2 (Anzahl der Einstellmöglichkeiten).
— Für jeden Datenanschluß AS und für jeden Einstellanschluß E wird eine Spalte in der Verbindungsmatrix vorgesehen.
— Für jede Einstellmöglichkeit wird ein Einstellcode festgelegt.
— Für jede Einstellmöglichkeit werden die möglichen Bitkombinationen auf den Datenanschlüssen AS festgelegt ; für jede Bitkombination ist eine Zeile in der Verbindungstabelle notwendig.
— Anschließend wird die Verbindungstabelle minimiert.

Anhand eines Beispiels wird dies erläutert :

Es soll eine Verbindungstabelle für ein Verbindungsnetzwerk VN mit vier Datenanschlüssen AS1 bis AS4 realisiert werden. In der ersten Einstellmöglichkeit soll AS1 mit AS2 und AS3 mit AS4 verbunden werden. Bei der zweiten Einstellmöglichkeit soll AS1 mit AS2, AS3, AS4 verbunden werden. Dann wird nur ein einziger Einstellanschluß E benötigt, da es nur zwei Möglichkeiten gibt. Die Signale auf den Datenanschlüssen AS werden mit a1 bis a4 bezeichnet, das Signal auf der Einstelleitung mit m1 Die Verbindungstabelle sieht dann folgendermaßen aus :

```
a1, a2, a3, a4, m1.
 0   0   0   0   0
 0   0   1   1   0
 1   1   0   0   0
 1   1   1   1   0
 0   0   0   0   1
 1   1   1   1   1
```

Bei den erster vier Zeilen der Verbindungsmatrix liegt eine Verbindung zwischen den Datenanschlüssen AS1 mit AS2 und zwischen den Datenanschlüssen AS3 mit AS4 vor. Bei den letzten beiden Zeilen der Verbindungsmatrix sind die Datenanschlüsse AS1 mit AS2, AS3 und AS4 verbunden.

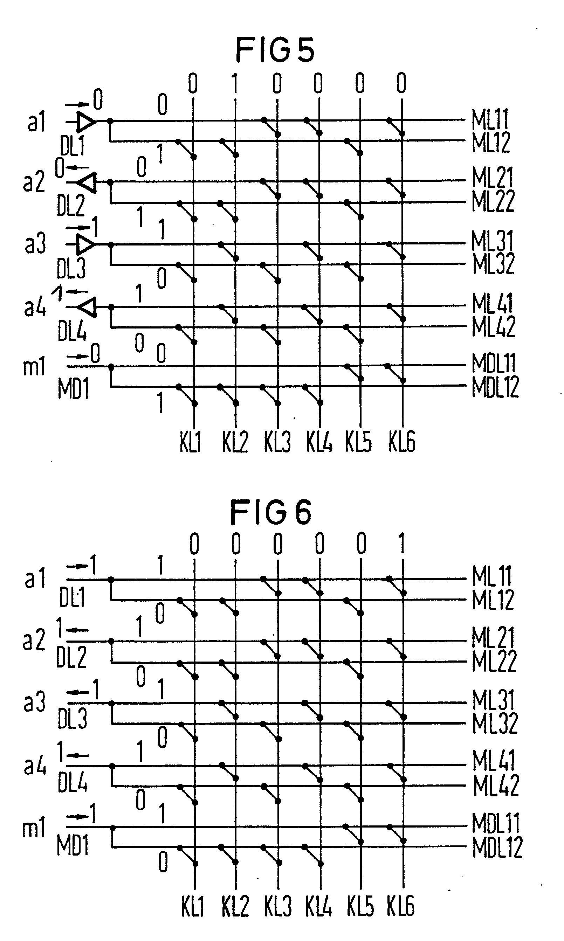

Die Programmierung der Matrix MA entsprechend dieser Verbindungstabelle kann den Fig. 5 und 6 entnommen werden. Dabei sind in den Spalten der Matrix die Zeilen der Verbindungstabelle gespeichert oder in den Zeilen der Matrix die Spalten der Verbindungstabelle realisiert. Mit Hilfe eines Striches ist angedeutet, ob eine Verbindung zwischen einer Datenleitung oder Einstellteilleitung und einer Koppelleitung besteht. Die Programmierung sei anhand der Datenleitung DL1 und der Einstelleitung MD1 erläutert. Für die Datenleitung DL1 ist entsprechend der Verbindungsmatrix für a1 folgende Programmierung vorgesehen :

0 0 1 1 0 1.

Bei einer binären 0 ist jeweils eine Verbindung zwischen der Matrixleitung ML12 und der zugeordneten Koppelleitung, bei der Programmierung einer binären 1 eine Verbindung zwischen der Matrixleitung ML11 und einer Koppelleitung KL vorgesehen. Entsprechendes gilt auch für die Einstelleitung MD entsprechend der Spalte der Verbindungsmatrix für m1. Die Programmierung ist entsprechend 0 0 0 0 1 1.

In Fig. 5 ist die Übertragung der Daten über die Datenleitung DL angegeben unter der Voraussetzung, daß der Einstellcode binär 0 ist. Der als Eingang geschalteten Datenleitung DL1 werde eine binäre 0, der als Eingang geschalteten Datenleitung DL3 eine binäre 1 zugeführt. Dann stellt sich auf der Koppelleitung KL1 eine binäre 0 wegen a3, auf der Koppelleitung KL2 eine binäre 1 wegen a3, auf der Koppelleitung KL3 eine binäre 0 wegen a1, auf der Koppelleitung KL4 eine binäre 0 wegen a1 und auf den Koppelleitungen KL5 und KL6 eine binäre 0 wegen m1 ein. Auf der als Ausgang geschalteten Datenleitung DL2 erscheint eine binäre 0, da die binäre 1 auf der Koppelleitung KL2 nicht zum Ausgang AS2 gelangen kann. Auf der Datenleitung DL4 erscheint dagegen eine binäre 1, da die binäre 1 auf der Koppelleitung KL2 zum Ausgang AS4 gelangen kann.

Die Erläuterung der Funktion zeigt, daß sich eine binäre 0 auf einer der Matrixleitungen ML oder Einstellteilleitung MDL über ein Schaltelement SE zur Koppelleitung KL durchsetzt. Umgekehrt setzt sich eine binäre 1 auf einer Koppelleitung KL auf die damit verbundenen Datenleitungen DL durch, wenn diese Datenleitungen als Ausgang geschaltet sind.

Die Funktion der Verbindungstabelle soll anhand eines zweiten Ausführungsbeispiels entsprechend Fig. 6 noch einmal erläutert werden. Jetzt sei der Einstellcode binär 1. Wenn der Datenleitung DL1, die als Eingang geschaltet ist, eine binäre 1 zugeführt wird, dann stellt sich auf den Koppelleitungen KL1 bis KL5 binär 0, auf der Koppelleitung KL6 eine binäre 1 ein. Entsprechend der Programmierung setzt sich die binäre 1 auf der Koppelleitung KL1 auf alle als Ausgang geschalteten DL2 bis DL4 durch, so daß das Ausgangssignal a2 bis a4 binär 1 ist. Somit wird die binäre 1 von der Datenleitung DL1 auf die Datenleitungen DL2, DL3 und DL4 übertragen.

Mit Hilfe des Einstellcodes kann somit festgelegt werden, welche Datenleitungen DL miteinander verbunden sind. Die Richtung der Datenübertragung wird dagegen mit Hilfe des Steuersignals ST festgelegt. Die nachfolgende Tabelle 2 zeigt, wann ein Datenanschluß AS Eingang oder Ausgang sein kann :

| ml | AS1 | AS2 | AS3 | AS4 |
|----|-----|-----|-----|-----|
| 0 | E | A | E | A |
| 0 | A | E | E | A |
| 0 | E | A | A | E |
| 0 | A | E | A | E |
| 1 | E | A | A | A |
| 1 | A | E | A | A |
| 1 | A | A | E | A |
| 1 | A | A | A | E |

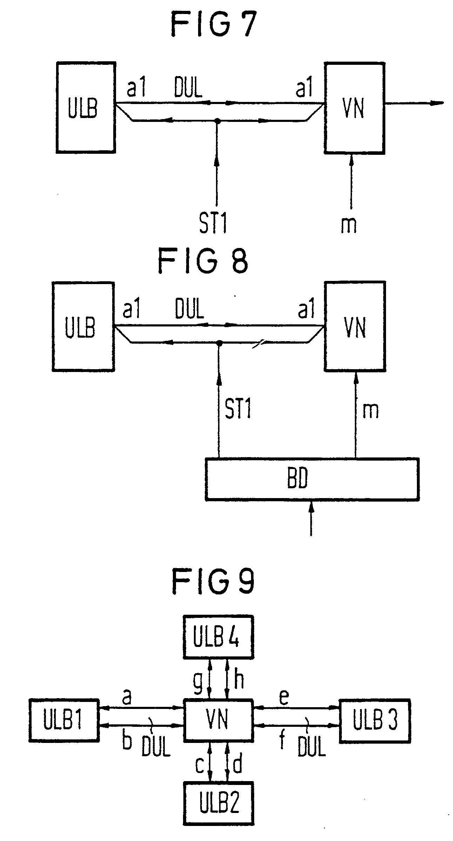

Der Einstellcode stellt also die internen Verbindungen zwischen den Datenleitungen DL ein. Die Steuerleitung ST stellt die Datenrichtung auf den Datenleitungen ein. Es darf immer nur eine Datenleitung, die als Eingang geschaltet ist, mit Datenleitungen, die als Ausgang geschaltet sind, verbunden werden. Eine andere Verbindung ist nicht erlaubt. Die Überwachungseinrichtung US aktiviert bei unerlaubtem Verbindungsaufbau ein Signalverbindungsfehler FB. Fig. 7 zeigt eine Verbindung zwischen einer Schaltungsanordnung ULB und dem Verbindungsnetzwerk VN. Wenn die Datenübertragungsleitung DUL im ULB als Eingang geschaltet ist, dann muß sie im Verbindungsnetzwerk VN als Ausgang geschaltet sein. Wenn die Datenübertragungsleitung DUL im ULB als Ausgang geschaltet ist, dann muß sie im Verbindungsnetzwerk VN als Eingang geschaltet sein. In der Überwachungseinrichtung US sind die erlaubten Verbindungen in einem ROM, RAM oder PLA gespeichert. Die erlaubten Verbindungen sind in der bereits oben dargestellten Tabelle 2 angegeben.

Wenn sichergestellt ist, daß keine unerlaubten Verbindungen auftreten, dann kann auf die Überwachungseinrichtung US verzichtet werden. Dies ist z.B. dann der Fall, wenn gemäß Fig. 8 ein Befehlsdecoder BD vorgesehen ist, in dem die erlaubten Verbindungen gespeichert sind.

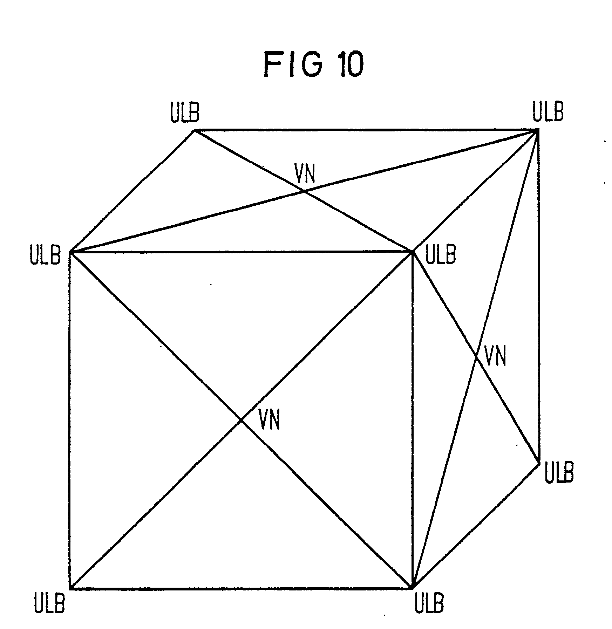

Aus den Fig. 9 und 10 ergeben sich weitere Beispiele für Verbindungsnetzwerke mit vier Schaltungsanordnungen ULB. Das Verbindungsnetzwerk der Fig. 9 sieht zwischen jedem ULB und dem Verbindungsnetzwerk VN jeweils zwei Datenübertragungsleitungen DUL vor. Über das Verbindungsnetzwerk VN kann jede dieser Datenübertragungsleitungen mit jeder Datenübertragungsleitung einer anderen Schaltungsanordnung verbunden werden. Aus Fig. 10 ergibt sich ein Netzwerk aus mehreren Verbindungsnetzwerken, wobei jedes Verbindungsnetzwerk jeweils mit vier Schaltungsanordnungen ULB zusammenarbeitet. Die Schaltungsanordnungen ULB können zu einem Würfel zuammengeschaltet sein, wobei in jedem diagonalen Schnittpunkt jeder Würfelerke ein Verbindungsnetzwerk angeordnet ist.

## Patentansprüche

1. Verbindungsnetzwerk zur einstellbaren Verbindung von Schaltungsanordnungen, insbesondere programmierbaren Schaltungsanordnungen, mit folgenden Merkmalen :
— es ist eine Matrix (MA) aus einer Verbindungsmatrix (V-MA) und einer Einstellmatrix (E-MA) vorgesehen,
— die Verbindungsmatrix besteht aus bidirektional betreibbaren Datenleitungen (DL) und damit kreuzenden Koppelleitungen (KL) mit an den Kreuzungsstellen liegenden programmierbaren Koppelelementen (KE),
— die Datenanschlüsse (AS) der Datenleitungen (DL) sind mit den Anschlüssen der Schaltungsanordnungen (ULB) verbunden,
— die Einstellmatrix (E-MA) besteht aus den Koppelleitungen (KL) und damit kreuzenden Einstelleitungen (MD) mit an den Kreuzungsstellen liegenden programmierbaren Koppelelementen (KE),
— durch Anlegen eines Einstellcodes an die Einstelleitungen (MD) ist festlegbar, welche Datenanschlüsse innerhalb der programmierten Verbindungsmatrix (V-MA) miteinander verbunden sind.

2. Verbindungsnetzwerk nach Anspruch 1, dadurch **gekennzeichnet**, daß die Koppelelemente (KE) abschaltbare Schaltelemente (SE) sind, die jeweils zwischen einer Datenleitung (DL) bzw. Einstelleitung (MD) und einer Koppelleitung (KL) angeordnet sind.

3. Verbindungsnetzwerk nach Anspruch 1 oder 2, dadurch **gekennzeichnet**, daß in jeder Datenleitung (DL) eine Eingangsschaltung (EG) angeordnet ist, an der ein Steuersignal (ST) anliegt, das in der Eingangsschaltung angeordnete Treiberstufen so steuert, daß der Datenanschluß entweder ein Dateneingang oder Datenausgang darstellt.

4. Verbindungsnetzwerk nach Anspruch 3, dadurch **gekennzeichnet,** daß sich jede Datenleitung (DL) in zwei Matrixleitungen (ML1, ML2) verzweigt, wobei die Eingangsschaltung (EG) aus einer ersten, in der ersten Matrixleitung (ML1) liegenden Treiberstufe, aus einer zweiten, invertierenden, in der zweiten Matrixleitung (ML2) liegenden Treiberstufe (T2) und aus einer dritten, die erste Treiberstufe (T1) in Gegenrichtung überbrükkenden Treiberstufe (T3) besteht und jede Treiberstufe durch das Steuersignal (ST) abschaltbar ist.

5. Verbindungsnetzwerk nach einem der vorhergehenden Ansprüche, dadurch **gekennzeichnet,** daß jede Einstellleitung (MD) sich in zwei Matrixleitungen (MDL1, MDL2) verzweigt, von denen die eine ein Einstellsignal (m), die andere das Einstellsignal invertiert erhält.

6. Verbindungsnetzwerk nach Anspruch 4 oder 5 dadurch **gekennzeichnet,** daß pro Datenleitung (DL) bzw. Einstelleitung (MD) pro Koppelelement (KE) zwei Schaltelemente (SE) zwischen den diesen zugeordneten zwei Matrixleitungen (ML1, ML2 ; MDL1, MDL2) und den Koppelleitungen (KL) angeordnet sind, die entsprechend einer Verbindungtabelle programmiert sind.

7. Verbindungsnetzwerk nach Anspruch 6, dadurch **gekennzeichnet,** daß zur Programmierung eines Binärwertes der einen Art ("1") ein nicht abgeschaltetes Schaltelement (SE) zwischen der einen Matrixleitung (ML1) und einer Koppelleitung (KL), zur Programmierung des Binärwertes der anderen Art ("O") ein nicht abgeschaltetes Schaltelement zwischen der anderen Matrixleitung (ML2) und der Koppelleitung (KE) angeordnet ist.

8. Verbindungsnetzwerk nach Anspruch 7, dadurch **gekennzeichnet,** daß zur Programmierung eines dritten Zustandes zwischen den beiden Matrixleitungen (ML) einer Datenleitung (DL) und einer Koppelleitung (KL) nur abgeschaltete Schaltelemente angeordnet sind.

9. Verbindungsnetzwerk nach einem der Ansprüche 3 bis 8, dadurch **gekennzeichnet,** daß bei Betreiben einer Datenleitung (DL) als Eingang die zugeordneten Matrixleitungen (ML1, ML2) über einen Widerstand mit einer ersten Betriebsspannungsquelle (VS), bei Betrieb als Ausgang über einen Widerstand mit einer zweiten Betriebsspannungsquelle (VC) verbunden sind.

10. Verbindungsnetzwerk nach Anspruch 9, dadurch **gekennzeichnet,** daß die Koppelleitungen (KL) über einen Widerstand mit der ersten Betriebsspannungsquelle (VS) verbunden sind.

11. Verbindungsnetzwerk nach einem der vorhergehenden Ansprüche, dadurch **gekennzeichnet,** daß zusätzlich eine Überwachungseinrichtung (US) vorgesehen ist, in der die erlaubten Verbindungen zwischen den Datenanschlüssen (AS) gespeichert sind und die mit den Leitungen für die Steuersignale (ST) und den Einstellcode verbunden ist.

12. Anordnung unter Verwendung von Verbindungsnetzwerken nach einem der vorhergehenden Ansprüche, dadurch **gekennzeichnet,** daß eine Mehrzahl von Verbindungsnetzwerken vorgesehen sind, die jeweils mit einer festlegbaren Anzahl von Schaltungsanordnungen (ULB) verbunden sind.

## Claims

1. Connection network for adjustable connection of circuit arrangements, particularly programmable circuit arrangements, having the following features :
   — a matrix (MA) of a connecting matrix (V-MA) and of an adjusting matrix (E-MA) is provided,
   — the connecting matrix consists of bidirectionally operable data lines (DL) and of switching lines (KL) intersecting the former and having programmable switching elements (KE) located at the points of intersection,
   — the data terminal s (AS) of the data lines (DL) are connected with the terminals of the circuit arrangements (ULB),
   — the adjusting matrix (E-MA) consists of the switching lines (KL) and of adjusting lines (MD) intersecting the former and having programmable switching elements (KE) located at the points of intersection,
   — by applying an adjustment code to the adjusting lines (MD), it can be determined which data terminals are connected to one another within the programmed connecting matrix (V-MA).

2. Connection network according to Claim 1, characterised in that the switching elements (KE) are disconnectable switching elements (SE) which are in each case arranged between a data line (DL) or adjusting line (MD), respectively, and a switching line (KL).

3. Connection network according to Claim 1 or 2, characterised in that in each data line (DL), an input circuit (EG) is arranged at which a control signal (ST) is present which controls driver stages arranged in the input circuit, in such a manner that the data terminal represents either a data input or a data output.

4. Connection network according to Claim 3, characterised in that each data line (DL) branches into two matrix lines (ML1, ML2), in which arrangement the input circuit (EG) consists of a first driver stage located in the first matrix line (ML1), of a second inverting driver stage (T2) located in the second matrix line (ML2) and

6

of a third driver stage (T3) which bridges the first driver stage (T1) in the opposite direction, and each driver stage can be disconnected by the control signal (ST).

5. Connection network according to one of the preceding claims, characterised in that each adjusting line (MD) branches into two matrix lines (MDL1, MDL2), one of which receives an adjusting signal (m) and the other one of which receives the inverted adjusting signal.

6. Connection network according to Claim 4 or 5, characterised in that two switch elements (SE) per data line (DL) or adjusting line (MD), respectively, are arranged per switching element (KE) between the two matrix lines (ML1, ML2, MDL1, MDL2) allocated to these and the switching lines (KL), which are programmed in accordance with a connection table.

7. Connection network according to Claim 6, characterised in that a non-disconnected switch element (SE) is arranged between one matrix line (ML1) and a switching line (KL) for programming a binary value of one type ("1") and a non-disconnected switch element (SE) is arranged between the other matrix line (ML2) and the switching line (KE) for programming the binary value of the other type ("0").

8. Connection network according to claim 7, characterised in that only disconnected switch elements are arranged between the two matrix lines (ML) of a data line (DL) and of a switching line (KL) for programming a third state.

9. Connection network according to one of Claims 3 to 8, characterised in that, when a data line (DL) is operated as input, the associated matrix lines (ML1, ML2) are connected via a resistor to a first operating voltage source (VS) and, with operation as output, the associated matrix lines are connected to a second operating voltage source (VC) via a resistor.

10. Connection network according to Claim 9, characterised in that the switching lines (KL) are connected to the first operating voltage source (VS) via a resistor.

11. Connection network according to one of the preceding claims, characterised in that a monitoring device (US) is additionally provided in which the permitted connections between the data terminals (AS) are stored and which is connected to the lines for the control signals (ST) and for the adjustment code.

12. Arrangement using connection networks according to one of the preceding claims, characterised in that a plurality of connection networks is provided which are in each case connected to a definable number of circuit arrangements (ULB).

## Revendications

1. Réseau de connexions pour réaliser une connexion réglable de montages, notamment de montages programmables, présentant les caractéristiques suivantes :
   — il est prévu une matrice (MA) formée d'une matrice de connexions (V-MA) et d'une matrice de réglage (E-MA),
   — la matrice de connexions est constituée par des lignes de transmission de données (DL) pouvant avoir un service bidirectionnel et par des lignes de couplage (KL) croisant les lignes précédentes et comportant des éléments de couplage programmables (KE) situés au niveau des points d'intersection,
   — les bornes de transmission de données (AS) des lignes de transmission de données (DL) sont raccordés aux bornes des montages (ULB),
   — la matrice de réglage (E-MA) est constituée par des lignes de couplage (KL) et par des lignes de réglage (MD) qui recoupent les lignes précédentes et comportent des éléments de couplage programmables (KE) situé au niveau des points d'intersection,
   — l'application d'un code de réglage aux lignes de réglage (MD) permettant de déterminer quelles bornes de transmission de données sont raccordées entre elles à l'intérieur de la matrice programmée de connexions (V-MA).

2. Réseau de connexions suivant la revendication 1, caractérisé par le fait que les éléments de couplage (KE) sont des éléments de commutation (SE) pouvant être sectionnés, qui sont disposés respectivement entre une lige de transmission de données (DL) ou la ligne de réglage (MD) et une ligne de couplage (KL).

3. Réseau de connexions suivant la revendication 1 ou 2, caractérisé par le fait que dans chaque ligne de transmission de données (DL) est disposé un circuit d'entrée (EG), auquel est appliqué un signal de commande (ST), qui commande des étages d'attaque disposés dans le circuit d'entrée de telle sorte que la borne de transmission de données représente soit une entrée de données, soit une sortie de données.

4. Réseau de connexions suivant la revendication 3, caractérisé par le fait que chaque ligne de transmission de données (DL) se ramifie en deux lignes (MDL1, MDL2) de la matrice, le circuit d'entrée (EG) est constitué par un premier étage d'attaque situé dans la première ligne (ML1) de la matrice, par un second étage d'attaque inverseur (T2) situé dans la seconde ligne (ML2) de la matrice et par un troisième étage d'attaque (T3) shuntant le premier étage d'attaque (T1) en sens opposé, et que chaque étage d'attaque peut être placé à l'état bloqué par le signal de commande (ST).

5. Réseau de connexions suivant l'une des revendications précédentes, caractérisé par le fait que chaque ligne de réglage (MD) se ramifie en deux lignes (MDL1, MDL2) de la matrice, dont l'une reçoit le signal de réglage (m) et l'autre le signal de réglage inversé.

6. Réseau de connexions suivant la revendication 4 ou 5, caractérisé par le fait que pour chaque ligne de transmission de données (DL) ou pour chaque ligne de réglage (MD), au niveau de chaque élément de couplage (KE), il est prévu, entre deux lignes (ML1, ML2, MDL1, MDL2) de la matrice, associées auxdites lignes, et les lignes de couplage (KL), deux éléments de commutation (SE) qui sont programmés conformément à un tableau de connexions.

7. Réseau de connexions suivant la revendication 6, caractérisé par le fait que pour la programmation d'une valeur binaire d'un type ("1"), un élément de commutation (SE) qui n'est pas sectionné, est disposé entre une ligne (ML) de la matrice et une ligne de couplage (KL), et que pour la programmation de la valeur binaire de l'autre type ("O"), un élément de commutation non sectionné est disposé entre l'autre ligne (ML2) de la matrice et la ligne de couplage (KE).

8. Réseau de connexions suivant la revendication 7, caractérisé par le fait que pour la programmation d'un troisième état, seuls des éléments de commutation sectionnés sont disposés entre les deux lignes (ML) de la matrice, d'une ligne de transmission de données (DL) et une ligne de couplage (KL).

9. Réseau de connexions suivant l'une des revendications 3 à 8, caractérisé par le fait que, lors du fonctionnement d'une ligne de transmission de données (DL) en tant qu'entrée, les lignes associées (ML1, ML2) de la matrice sont raccordées par l'intermédiaire d'une résistance à une première source de tension de service (VS), tandis que dans le cas du fonctionnement en tant que sortie, lesdites lignes sont raccordées par l'intermédiaire d'une résistance à une seconde source de tension de service (VC).

10. Réseau de connexions suivant la revendication 9, caractérisé par le fait que les lignes de couplage (KL) sont raccordées par l'intermédiaire d'une résistance à la première source de tension de service (VS).

11. Réseau de connexions suivant l'une des revendications précédentes, caractérisé par le fait qu'il est en outre prévu un dispositif de contrôle (US), dans lequel sont mémorisées les connexions autorisées entre les bornes de transmission de données (AS) et qui est raccordé aux lignes pour les signaux de commande (ST) et le code de réglage.

12. Dispositif utilisant des réseaux de connexions suivant l'une des revendications précédentes, caractérisé par le fait qu'il est prévu une multiplicité de réseaux de connexions qui sont raccordés respectivement à un nombre pouvant être déterminé de montages (ULB).

FIG 1

FIG 2

FIG 3

# FIG 4

# FIG 5

# FIG 6

## FIG 7

## FIG 8

## FIG 9

# FIG 10